## Europäisches Patentamt
## European Patent Office
## Office européen des brevets

(19)

(11) Veröffentlichungsnummer: **0 178 402**
**B1**

(12) # EUROPÄISCHE PATENTSCHRIFT

(45) Veröffentlichungstag der Patentschrift:
08.03.89

(21) Anmeldenummer: **85109624.8**

(22) Anmeldetag: **31.07.85**

(51) Int. Cl.⁴: **G 08 B 29/00, H 03 K 5/19**

(54) **Überwachungsschaltung.**

(30) Priorität: **06.09.84 CH 4252/84**

(43) Veröffentlichungstag der Anmeldung:
**23.04.86 Patentblatt 86/17**

(45) Bekanntmachung des Hinweises auf die Patenterteilung:
**08.03.89 Patentblatt 89/10**

(84) Benannte Vertragsstaaten:
**AT BE CH DE FR GB IT LI LU NL SE**

(56) Entgegenhaltungen:
**DE-A-2 440 162**
**DE-A-2 848 641**
**US-A-2 905 861**
**US-A-3 496 477**

(73) Patentinhaber: **SIEMENS- ALBIS AKTIENGESELLSCHAFT, EGA1/Verträge und Patente Postfach, CH- 8047 Zürich (CH)**

(72) Erfinder: **Frischknecht, Urs, Kirchweg 139, CH- 8102 Oberengstringen (CH)**
Erfinder: **Skalsky, Peter, Schneebelistrasse 7, CH- 8048 Zürich (CH)**

## Beschreibung

Die vorliegende Erfindung betrifft eine Schaltungsanordnung gemäss dem Oberbegriff des Patentanspruches 1.

Solche Überwachungsschaltungen, oft auch "Watch Dog-Schaltungen" genannt, haben die Aufgabe, den Ausfall eines Systems unverzüglich festzustellen und dabei ein Signal abzugeben, das den Ausfall anzeigende Elemente aktiviert. Bekannte derartige Schaltungen weisen mindestens ein Zeitglied auf, das nach einer vorgegebenen Zeltspanne abläuft, wenn es nicht vor Ablauf dieser Zeit neu gestartet wird. Wenn das Zeitglied infolge Ausbleibens des Startsignals abläuft, wird ein Alarmsignal erzeugt. Als Zeltglieder (siehe z. B. DE-A-2 440 162 und DE-A-2 848 641) werden monostabile Klippstufen oder Zähler eingesetzt, die durch mehr oder weniger aufwendige Logikschaltungen angesteuert werden. Ein fehlerhaftes Verhalten der Zeltglieder selbst oder der Logikschaltungen bewirkt nicht mit absoluter Sicherheit die Erzeugung eines Alarmsignais am Ausgang der Überwachungsschaltung, da dieser bei Auftreten eines Fehlers rein zufällig einen der zwei Zustände "Alarm" oder "kein Alarm" einnehmen und beibehalten kann, welcher Zustand nicht dem tatsächlichen Zustand des zu überwachenden Systems entsprechen muss. Es kann daher vorkommen, dass dauernd ein Alarmsignal ansteht, obwohl das zu überwachende System nicht ausgefallen ist. Umgekehrt kann ferner der unerwünschte Fall eintreten, dass infolge eines Fehlers in der Überwachungsschaltung kein Alarmsignal erzeugt wird, obwohl das zu überwachende System infolge Ausfall kein Startsignal mehr an das Zeitglied abgibt.

Die Aufgabe der vorliegenden Erfindung besteht darin, eine einfache Überwachungsschaltung zu schaffen, bei der diese Unsicherheit bezüglich des Zustandes ihres Ausganges nicht besteht, indem bei Ausfall des zu überwachenden Systems und/oder der Überwachungsschaltung selbst in jedem Fall ein Alarmsignal am Ausgang abgegeben wird. Die Losung dieser Aufgabe gelingt erfindungsgemäss mit einer Schaltungsanordnung, wie sie im Anspruch 1 gekennzeichnet ist. Ausgestaltungen der Erfindung sind in weiteren Ansprüchen angegeben.

Ein Ausführungsbeispiel der Erfindung wird nachfolgend anhand einer Zeichnung näher erläutert. Das hinsichtlich eines möglichen Ausfalls zu überwachende taktgesteuerte System S, beispielsweise ein Prozessor in einer programmgesteuerten Anlage, ist mit einem Frequenzübersetzer FU verbunden. Das System S gibt in bestimmten Zeitabständen, z. B. jeweils nach einem Durchlauf aller internen Verarbeitungsroutinen, ein Impulsförmiges Referenzsignal r1 ab, das dem Frequenzübersetzer FU über seinen Eingang E1 zugeführt wird. Das Referenzsignal r1 wird programmässig im System S erzeugt. Seine Frequenz ist so gewählt, dass die Verarbeitungsabläufe im System S nicht beeinträchtigt werden. Der Frequenzübersetzer FU erzeugt an seinen beiden Ausgängen A1, A2 zwei gegeneinander um 180 Grad phasenverschobene Signale s1, s2 mit gleicher Frequenz, die um ein Vielfaches grösser ist als die Referenzfrequenz r1 des Systems S, welche in der Regel relativ klein ist. In einem praktisch ausgeführten Beispiel beträgt die Referenzfrequenz r1 1 Hz und die übersetzte Frequenz der Signale s1, s2 20 kHz. Als Frequenzübersetzer FU kann vorteilhafterweise ein Mikrocomputer eingesetzt werden, der durch entsprechende Programmierung aus dem empfangenen Referenzsignal r1 die beiden gegeneinander um eine halbe Periodendauer verschobenen Signale s1 und s2 erzeugt. Eine derartige Erzeugung von frequenzübersetzten Signalen aus einem gegebenen Signal ist bekannt, weshalb hier nicht weiter darauf eingegangen wird. Damit lässt sich in relativ einfacher Weise das Frequenzübersetzungsverhältnis den jeweiligen Gegebenheiten anpassen. Die frequenzübersetzten Signale s1, s2 werden auf je einen Eingang einer Trennstufe TS geführt. Die beiden Eingänge führen auf je einen Signalpfad mit einer als Stromverstärker wirkenden Darlington-Stufe D1 bzw. D2, deren einer Anschluss an einem Bezugspotential und deren anderer Anschluss mit dem einen bzw. dem anderen Ende der Primärwicklung eines Impulsübertragers T verbunden ist. Der Mittelabgriff der Primärwicklung des Übertragers T liegt an einem Speisepotential. Falls notwendig kann vor den Darlington-Stufen D1, D2 noch je eine Treiberstufe eingefügt werden, die eine zur Ansteuerung der Stromverstärkerstufen genügende Leistung liefert. Die Sekundärwicklung des Übertragers T ist mit einem Brückengleichrichter (Doppelweggleichrichter) GR verbunden. An dessen Ausgangsklemmen ist die Spule eines Relais R angeschlossen, das einen Alarmkontakt K1 aufweist, der in einem zu einer Alarmeinrichtung W führenden Stromkreis angeordnet ist. In einem zum Frequenzübersetzer FU zurückführenden Stromkreis kann ein Kontrollkontakt K2 des Relais R vorgesehen werden.

Die Wirkungsweise dieser Schaltungsanordnung ist kurz folgende: Solange das Referenzsignal r1 im Frequenzübersetzer FU eintrifft, gelangen die von diesem erzeugten frequenzübersetzten Signale s1 und s2 im Gegentakt auf die Primärseite des Übertragers T, so dass auf dessen Sekundärseite ein Impulsförmiges Wechselspannungssignal entsteht. Das Frequenzübersetzungsverhältnis wird dabei so gewählt, dass sich eine optimale Signalübertragung mit einem möglichst kleinen Übertrager T einstellt. Das sekundärseitige Wechselspannungssignal wird durch Doppelweggleichrichtung in ein Gleichspannungssignal umgewandelt, das das Relais R erregt, wodurch dessen Kontakte K1 und K2 in die geöffnete Schaltlage gebracht werden. Je nach Frequenz des auf der Sekundärseite des Übertragers 7 abgegebenen Signals kann parallel zum Relais R noch ein Kondensator C vorgesehen werden, der die erzeugte Gleichspannung glättet und damit ein einwandfreies Halten des Relais R gewährleistet. Solange das System S ein Referenzsignal r1 mit in einem vorgegebenen Bereich liegender Frequenz abgibt, erzeugt der Frequenzübersetzer FU die Signale s1 und s2. Bei Ausbleiben des Referenzsignals r1 schliessen die Kontakte K1, K2 und die Alarmeinrichtung W wird aktiviert.

Über den Kontrollkontakt K2 wird der Zustand des Relais R an einen Eingang Z des Frequenzübersetzers FU zurückgemeldet. Diese Zustandsmeldung kann in vorteilhafter Weise wie folgt ausgenützt werden: Wenn bei Vorhandensein des Referenzsignals r1 am Eingang Z des Frequenzübersetzers FU ein dem Zustand "kein Alarm" entsprechendes Signal anliegt, schickt der Frequenzübersetzer FU ein Signal r2 an das zu überwachende System 5 zurück. Wird hingegen bei Vorhandensein des Signals r1 die Alarmeinrichtung W infolge eines Fehlers in der Trennstufe TS aktiviert, wird dies dem Frequenzübersetzer FU durch die über den Kontrollkontakt K2 herbeigeführte Zustandsänderung an seinem Eingang Z gemeldet. Als Folge dieser Zustandsänderung unterdrückt der Frequenzübersetzer FU das Signal r2. Das Ausbleiben des Signals r2 bei gleichzeitigem Vorhandensein des Signals r1 interpretiert das System S als Fehler in der eigentlichen Überwachungsschaltung, d. h. entweder im Frequenzübersetzer FU oder in der Trennstufe TS. Das System S kann in diesem Fall die Ursache des Alarms durch eine entsprechende Anzeige "Ausfall der Überwachung" näher kennzeichnen.

Der im Ausführungsbeispiel gezeigte Aufbau der Trennstufe TS lässt erkennen, dass der Ausfall irgend eines ihrer Bauelemente immer den Abfall des Relais R zur Folge hat. Die erfindungsgemässe Schaltung löst daher sowohl bei Ausbleiben des Referenzsignals r1 infolge Ausfalls des zu überwachenden Systems S als auch bei Auftreten eines Fehlers in ihr selbst Alarm aus.

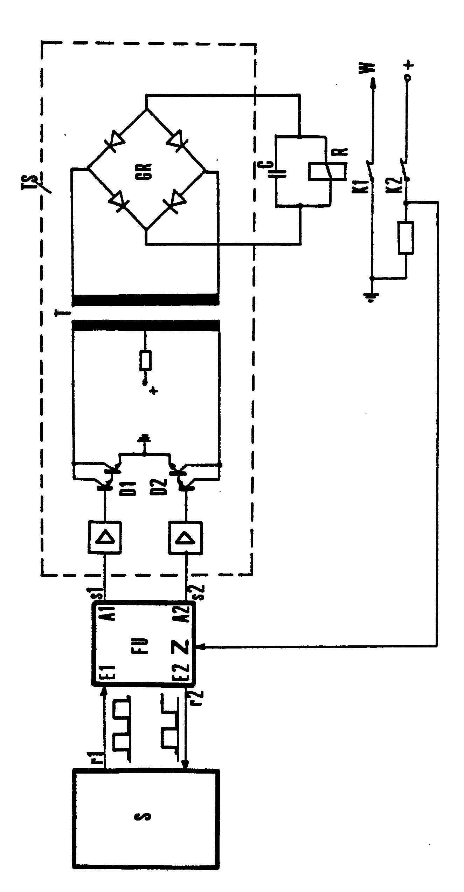

**Patentansprüche**

1. Überwachungsschaltung zur Feststellung und Anzeige des Ausfalls eines taktgesteuerten Systems mit einem bei Ausfall auf eine Alarmeinrichtung wirkenden Schaltelement, dadurch gekennzeichnet, dass ein Frequenzübersetzer (FU) vorhanden ist, dessen Eingang (E1) mit einem vom System (S) abgegebenen Referenzsignal (r1) beaufschlagt ist und der an seinen Ausgängen (A1, A2), zwei um die halbe Periodendauer gegeneinander verschobene Signale (s1, s2) abgibt, welche Ausgänge (A1, A2) mit der Primärwicklung eines Impulsübertragers (T) einer Trennstufe (TS) verbunden sind, in dessen Sekundärkreis das im Falle des Ausbleibens des durch die Signale (s1, s2) erzeugten Signales auf die Alarmeinrichtung (W) wirkende Schaltelement (R) angeordnet ist.

2. Überwachungsschaltung nach Anspruch 1, dadurch gekennzeichnet, dass im Sekundärkreis des Übertragers (T) ein Doppelweggleichrichter (GR) mit nachgeschaltetem Relais (R) vorgesehen ist, von dem ein Alarmkontakt (K1) zur Anschaltung der Alarmeinrichtung (W) dient.

3. Überwachungsschaltung nach Anspruch 2, dadurch gekennzeichnet, dass ein weiterer Kontakt des Relais (R) als Kontrollkontakt (K2) zur Anzeige des Relaiszustandes dient.

4. Überwachungsschaltung nach Anspruch 3, dadurch gekennzeichnet, dass wenn der Kontrollkontakt (K2) des Relais (R) bei gleichzeitigem Vorhandensein des Referenzsignals (r1) die Stellung "Alarm" einnimmt, dem System (S) eine Meldung "Überwachung ausgefallen" zuführbar ist.

5. Überwachungsschaltung nach einem der vorangehenden Ansprüche dadurch gekennzeichnet, dass als Frequenzübersetzer (FU) ein Mikrocomputer eingesetzt ist, mit dem das Frequenzübersetzungsverhältnis durch entsprechende Programmierung wahlweise festlegbar ist.

**Claims**

1. A monitoring circuit for the detection and display of failure of a clock-controlled system having a switching element which activates an alarm device in the event of a failure, characterised in that there is provided a frequency translator (FU) whose input (E1) is supplied with a reference signal (r1) emitted by the system (S) and which emits at its outputs (A1, A2) two signals (s1, s2) mutually offset by half the period duration, where said outputs (A1, A2) are connected to the primary winding of a pulse transformer (T) of a separating stage (TS) whose secondary circuit contains the switching element (R) which activates the alarm device (W) in the event of the absence of the signal produced by the signals (s1, s2).

2. A monitoring circuit as claimed in Claim 1, characterised in that the secondary circuit of the transformer (T) contains a full-wave rectifier (GR) having its output connected to a relay (R), an alarm contact (K1) of which serves to connect the alarm device (W).

3. A monitoring circuit as claimed in Claim 2, characterised in that a further contact of the relay (R) serves as a control contact (K2) for the display of the relay status.

4. A monitoring circuit as claimed in Claim 3, <u>characterised in</u> that if the control contact (K2) of the relay (R) assumes the "alarm" position when the reference Signal (r1) is simultaneously present, the system (S) can be supplied with a "monitoring failure" message.

5. A monitoring circuit as claimed in one of the preceding Claims, <u>characterised in that</u> a micro-computer is used as the frequency translator (FU), with which the frequency transformation ratio can be selectively set by appropriate programming.

**Revendications**

1. Circuit de surveillance pour déterminer et pour indiquer la défaillance d'un système commandé par des signaux de cadence, comportant un élément de commutation agissant, dans le cas d'une défaillance, sur un dispositif d'alarme, caractérisé par le fait qu'il est prévu un changeur de fréquence (FU) dont l'entrée (E1) reçoit un signal de référence (r1) fourni par le système (S) et qui émet à ses sorties (A1, A2) deux signaux (s1, s2) décalés entre eux d'une demi durée de période, lesdites sorties (A1, A2) étant reliées à l'enroulement primaire d'un transformateur d'impulsions (T) d'un étage séparateur (TS), dans le circuit secondaire duquel est disposé l'élément de commutation (R) qui agit sur le dispositif d'alarme (W), dans le cas de l'absence du signal produit par les signaux (s1, s2).

2. Circuit de surveillance selon la revendication 1, caractérisé par le fait qu'il est prévu dans le circuit secondaire du transformateur (T) un redresseur à deux alternances (GR) avec un relais aval (R) dont un contact d'alarme (K1) sert à brancher le dispositif d'alarme (W).

3. Circuit de surveillance selon la revendication 2, caractérisé par le fait qu'un second contact de relais (R) sert de contact de contrôle (K2) pour indiquer l'état du relais.

4. Circuit de surveillance selon la revendication 3, caractérisé par le fait que dans le cas où le contact de contrôle (K2) du relais (R) assume la position "alarme", et en cas de la présence simultanée du signal de référence (r1), une signalisation "surveillance défaillante" est susceptible d'être appliquée au système (S).

5. Circuit de surveillance selon l'une des revendications précédentes, caractérisé par le fait que l'on met en oeuvre, comme changeur de fréquence (FU), un microordinateur au moyen duquel on peut fixer au choix le rapport de transformation des fréquences, par une programmation correspondante.